# DEMANDE DE BREVET EUROPEEN

(11) **EP 1 288 344 A2**
(43) Date de publication de la demande: **05.03.2003**
(21) Numéro de dépôt: 02292086.2
(22) Date de dépôt: 22.08.2002
(51) Int. Cl.: C30B 11/00, C30B 35/00

(54) **Dispositif de compensation de volume dans une cartouche de solidification de deux charges liquides**

(30) Priorité: 24.08.2001 FR 0111097
(71) Demandeur: Commissariat à l'Energie Atomique, 75752 Paris Cedex 15 (FR); CENTRE NATIONAL D'ETUDES SPATIALES, 75001 Paris (FR)
(72) Inventeur: Salvi, Charles, 38000 Grenoble (FR); Garandet, Jean-Paul, 38000 Grenoble (FR); Borgis, André, 38000 Grenoble (FR)
(74) Mandataire: Ilgart, Jean-Christophe

(57) **Abrégé**

Deux charges à solidifier progressivement sont comprimées dans des alvéoles (5, 6) respectifs par des pistons (21, 22) du côté du liquide. Un ressort unique (26) repousse les pistons par le truchement d'une masse liquide (23) présente tout à l'arrière des alvéoles (5, 6) ainsi qu'à l'avant d'un logement (24) dans lequel le ressort (26) est contenu. Ainsi, des ressorts en graphite peuvent avantageusement être construits moins élancés, les pressions sont identiques par les deux charges et varient peu pendant la solidification grâce à la réduction de la détente du ressort consécutive à son élargissement. Des contrôles de solidification deviennent aussi plus faciles.

## Description

L'invention a trait à un dispositif de compensation de volume dans une cartouche de solidification de deux charges liquides, et son domaine est avant tout la croissance de corps tels que des cristaux par solidification progressive d'une charge versée à l'état liquide dans un creuset.

Les appareils existants comprennent en général une cartouche composée principalement d'un creuset évidé d'au moins un alvéole dans lequel une charge à solidifier est versée, ainsi qu'un four entourant le creuset et mobile par rapport à lui. Pour solidifier la charge, on dégage une longueur toujours plus importante du creuset en reculant progressivement le four et laissant la charge présente dans cette longueur se refroidir. Une précaution usuelle consiste à déposer un germe ayant la structure cristalline recherchée à l'extrémité de l'alvéole qui est dégagé en premier par le four. Ainsi, la charge solidifiée croît à partir du germe en imitant sa structure cristalline.

Un problème communément rencontré, notamment avec les corps enrichis d'un dopant, est de contrôler la composition des sections de la charge qui se solidifient successivement, afin de vérifier qu'elles gardent la bonne composition cristalline demandée. Un procédé de contrôle satisfaisant porte le nom de Seebeck et comporte quelques variantes. Il est fondé sur les propriétés thermodynamiques des mélanges mis à solidifier et sur l'exploitation d'un phénomène thermoélectrique.

Un mélange se solidifie à une température qui dépend de la composition de la fraction se solidifiant. Si on ajoute une charge servant de témoin dans un autre alvéole à côté de la charge principale, se solidifiant avec elle et ayant une composition connue avec certitude, telle que le corps de base de la charge principale à l'état pur, une mesure indirecte de la température de solidification de la charge principale devient possible en disposant deux électrodes sur les portions solidifiées des charges, en mesurant la différence de potentiel entre ces électrodes dans un circuit qui les relie, et en rapportant cette différence de potentiel à des résultats d'étalonnage. Quelques dispositions supplémentaires doivent être prises. C'est ainsi que les parties liquides des charges doivent être au même potentiel, ce qu'on accomplit en disposant une électrode supplémentaire, passive, qui joint les alvéoles en baignant les parties liquides des charges. De plus, les électrodes de mesure et les portions adjacentes des parties solidifiées des charges doivent être à la même température sous peine de produire un effet thermoélectrique supplémentaire qui modifierait la différence de potentiel à mesurer et brouillerait la mesure. C'est pourquoi les électrodes et les extrémités des charges solidifiées sortent du creuset et sont logées dans un système homogénéisateur de température en matière conductrice thermique et en contact avec les extrémités des charges et les électrodes, ce qui égalise leurs températures. Un dispositif actif d'égalisation peut être ajouté : il prend la forme, par exemple, d'une ou plusieurs spires de chauffage entourant la matière de l'homogénéisateur, ou de moyens indépendants de chauffage ou de refroidissement des extrémités des charges.

Un autre problème qu'on affronte est la contraction des charges quand elles se refroidissent et se solidifient. Si aucune précaution n'est prise, des bulles de cavitation apparaissent et sont évidemment désastreuses pour la qualité du produit obtenu. On les évite en maintenant comprimées les parties liquides des charges, et plus précisément en disposant des pistons glissant dans les alvéoles et des ressorts situés derrière les pistons pour les repousser et maintenir une contraction des charges.

On se heurte toutefois à des difficultés de fabrication de ces ressorts, qui doivent souvent être construits en des matières réfractaires inhabituelles comme le graphite, et avec des élancements importants pour s'adapter à la fois à la finesse des alvéoles et à des contractions importantes des charges sans laisser les pressions de compression varier beaucoup.

C'est pour échapper à cette difficulté que l'invention fut conçue. Elle autorise l'emploi de ressorts plus faciles à construire pour cette utilisation. Concrètement, elle concerne une cartouche de solidification de deux charges liquides, pouvant éventuellement convenir à un procédé de contrôle défini plus haut, et comprenant de toute façon un creuset à deux alvéoles cylindriques pour la charge et un moyen de poussée des charges comprenant deux pistons glissant dans les alvéoles derrière les charges et un ressort derrière les pistons, caractérisée en ce que le ressort est unique et le moyen de poussée comprend un plateau unique repoussé par le ressort, et un liquide comprimé entre le plateau et les pistons, les alvéoles débouchant dans un logement cylindrique unique contenant le ressort et où coulisse le plateau.

Il faut comprendre que les deux ressorts élancés logés dans les alvéoles sont remplacés par un ressort unique plus trapu disposé dans un logement dans lequel les deux alvéoles débouchent et qui transmet sa pression de compression aux pistons par le liquide intermédiaire. Cette disposition présente les avantages supplémentaires que des contractions différentes dans les alvéoles sont possibles sans inconvénient, et que des contractions importantes se produisent en ne provoquant qu'un déplacement modéré du ressort, puisque les alvéoles n'ont que des sections faibles par rapport au logement.

Il est avantageux que le liquide intermédiaire ait la composition soit d'une des charges, soit d'un corps de base des charges. Dans l'hypothèse où une fuite apparaîtrait au niveau d'un des pistons, il n'y aurait alors aucun risque de contamination du liquide des charges par le liquide intermédiaire. On pourrait de plus utiliser alors des pistons poreux qui ont l'avantage de permettre le dégazage des bulles présentes dans les parties liquides des charges.

En revanche, si un liquide intermédiaire totalement différent est utilisé, il est absolument nécessaire d'avoir des pistons étanches.

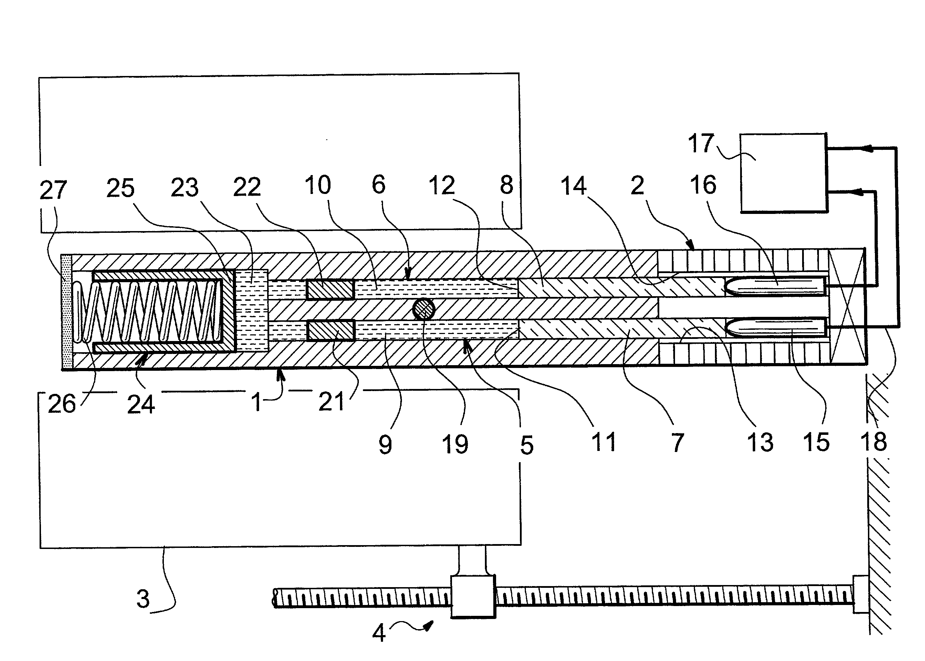

L'invention sera maintenant décrite en liaison à la figure unique. Un four de solidification comprend un creuset 1 élancé prolongé par un dispositif homogénéisateur 2 de température. Un four 3 entoure une portion du creuset 1 et se déplace en le dégageant progressivement à partir de régions proches de l'homogénéisateur 2 pendant le processus de solidification. Il peut à cet effet être uni à un support fixe par un dispositif de liaison 4 comprenant une glissière, une vis sans fin ou tout autre moyen analogue. Le mouvement de dégagement du four 3 est assuré par un dispositif de commande non représenté.

Le creuset 1 comprend deux alvéoles 5 et 6 longitudinaux et parallèles pour une charge principale et une charge de référence qu'on solidifie. Les charges comprennent chacune une portion solidifiée 7 ou 8 et une portion liquide 9 ou 10 séparées par une interface 11 ou 12 pouvant être à des endroits différents. Les portions solidifiées 7 et 8 sortent des alvéoles 5 et 6 pour pénétrer dans des alvéoles 13 et 14 de l'homogénéisateur 2 qui prolongent respectivement les précédents. Deux électrodes 15 et 16 en pointe s'étendent aux bouts des alvéoles 13 et 14 et sont reliées à un dispositif de mesure de tension 17 par un circuit électrique 18 qui les unit. De plus, une électrode 19 passive s'étend dans la masse du creuset 1, entre les alvéoles 5 et 6 de manière à y déboucher et à baigner les portions liquides 9 et 10. L'homogénéisateur 2 est en général un bloc de matière conductrice de chaleur pour porter les extrémités des portions solidifiées 7 et 8 à une même température, comme on l'a mentionné. On ne s'étendra pas sur sa description, qui ne regarde pas cette invention, et on se consacrera désormais aux éléments constitutifs de celle-ci.

Deux pistons 21 et 22 glissent à l'arrière des alvéoles 5 et 6 pour confiner les portions liquides 9 et 10. Derrière eux s'étend une masse liquide 23 qui occupe le reste des alvéoles 5 et 6 ainsi qu'une partie adjacente d'un logement cylindrique 24 évidé tout à l'arrière du creuset 1 et dans lequel débouchent les deux alvéoles 5 et 6. La masse liquide 23 est confinée dans une partie du logement 24 par un plateau de compression 25 repoussé par un ressort 26 comprimé entre ce plateau 25 et un couvercle 27 du logement 24, qui est assujetti au creuset 1. Ainsi, la compression du ressort produit une pression dans la masse liquide 23, qui est transmise aux portions liquides 9 et 10 des charges par les pistons 21 et 22. Cette pression varie peu à travers le processus de solidification, puisque le ressort 26 ne subira qu'une détente réduite et que les variations de pression s'égalisent d'ailleurs d'un alvéole 5 et 6 à l'autre à travers la masse liquide 23.

## Revendications

1. Cartouche de solidification de deux charges liquides comprenant un creuset (1) à deux alvéoles (5, 6) cylindriques pour les charges et un moyen de poussée des charges comprenant deux pistons (21, 22) glissant dans les alvéoles derrière les charges et un ressort (26) derrière les pistons, **caractérisée en ce que** le ressort est unique et le moyen de poussée comprend encore un plateau (25) unique repoussé par le ressort, et une masse liquide (23) comprimée entre le plateau et les pistons, les alvéoles débouchant dans un logement cylindrique unique (24) contenant le ressort et où coulisse le plateau.

2. Cartouche de solidification de deux charges liquides selon la revendication 1, **caractérisée en ce que** la masse liquide (23) a la composition soit d'une des charges, soit d'un corps de base de charges.

3. Cartouche de solidification de deux charges liquides selon la revendication 1, **caractérisée en ce que** la masse liquide (23) ne contient aucun des constituants d'une des charges et **en ce que** les deux pistons (21, 22) sont étanches.
